Europäisches Patentamt

European Patent Office

Office européen des brevets

(11) Publication number : **0 543 632 A1**

# (12) EUROPEAN PATENT APPLICATION

(21) Application number : **92310510.0**

(51) Int. Cl.⁵ : **G03F 7/033**

(22) Date of filing : **18.11.92**

(30) Priority : **19.11.91 US 794285**

(43) Date of publication of application :
**26.05.93 Bulletin 93/21**

(84) Designated Contracting States :
**AT BE CH DE DK ES FR GB GR IE IT LI LU NL PT SE**

(71) Applicant : **W.R. Grace & Co.-Conn.**
**Grace Plaza, 1114 Avenue of the Americas**
**New York, New York 10036-7794 (US)**

(72) Inventor : **Berrier, Arthur Leroy**
**8321 Fall Chill Court**
**Columbia, Maryland 21043 (US)**
Inventor : **Kanga, Rustom Sam**
**3427 Plumtree Drive - No.B**
**Columbia, Maryland 21043 (US)**

(74) Representative : **Bentham, Stephen**
**J.A. Kemp & Co. 14 South Square Gray's Inn**
**London, WC1R 5LX (GB)**

(54) Photosensitive elastomer polymer composition for flexographic printing plates processible in aqueous solutions.

(57) A water-developable flexographic printing plate is made by applying a layer of a photosensitive composition to a backing. The photosensitive composition includes an ABA triblock polymer, where B is a conjugated diene monomer, typically isoprene or butadiene, and A is an acrylate monomer, typically t-butylmethacrylate.

EP 0 543 632 A1

This invention relates to photosensitive polymer compositions and their method of manufacture. More specifically, it relates to making photosensitive compositions which have selected physical properties. The polymer composition may contain hydrolysed or ionomerised polymer and be used to make a water washable photosensitive article with improved physical properties. Such articles, called flexo plates, are especially useful for commercial printing and packaging of diverse products such as frozen food bags, orange juice cartons, potato chip bags, boxes, and envelopes. The invention further relates therefore to a flexographic relief printing plate comprising such a composition, methods of preparing such plates and of exposing and developing them and to apparatus comprising the exposed plates.

Photocurable prepolymers compositions are well known in the art for forming printing plates and other radiation sensitive articles. In the field of flexographic printing plates, the plates typically comprise a support and a photosensitive layer prepared from the photocurable composition. Additional layers on the plate include slip and release films to protect the photosensitive surface. Prior to processing the plate, the additional layers are removed, and the photosensitive layer is exposed to radiation in an imagewise fashion. The unexposed areas of the layer are then removed in developer baths.

Removal of unexposed layers comprising photocurable compositions such as those disclosed in U. S. Patent No. 2,760,863 require the use of developer baths of environmentally unsafe, organic solvents such as tetrachloroethylene, perchloroethylene, 2-butanone, benzene, toluene, xylene, trichloroethane and solvent mixtures such as tetrachloroethylene/n-butanol. These materials are hazardous due to their toxicity, high volatility and low flash point. Thus, recently there has been a strong interest in the field to develop photosensitive layers in non-organic solvent developing solutions, e.g. aqueous or alkaline-aqueous solutions. However, the compositions resulting from recent attempts to achieve aqueous developable plates demonstrate deficiencies in their mechanical properties.

For instance, in addition to possessing an aqueous developable photosensitive layer, a flexographic printing plate must be flexible enough to wrap around a printing cylinder, strong enough to withstand the rigors experienced during typical printing processes, soft enough to facilitate ink transfer during printing, and resistant enough to the particular ink solvent to avoid blurring of the image. Obtaining a balance of all these physical properties is no easy matter.

Previous aqueous developable compositions have not possessed all the desirable features such as flexibility, softness and solvent resistance to inks typically used in printing. For example, U. S. Patent No. 4,023,973 describes a photosensitive composition comprising of a maleic anhydride adduct of a 1,2-polybutadiene. However, because the 1,2 content of this material is very high, i.e. 70% or more, this composition has an undesirably high rubber hardness.

Furthermore, other water-developable photosensitive compositions which contain as the main component a high molecular weight polymer such as polyvinyl alcohol, cellulose, polyethylene oxide, or the like, are insufficient in flexibility and rubber hardness and hence are unsuitable for use in flexographic printing plates.

Finally, it is also important that the photosensitive layer of the printing plate be dimensionally stable during storage. For example, some compositions used for making plates have shown inferior stability properties when used in solid flexographic printing plates in that the compositions become tacky and pasty during storage. Those inferior properties have been attributed to the low molecular weight of the polymers used to prepare the printing plates. See U. S. Patent No. 4,762,892 to Koch et al. and discussion of low molecular weight polymers disclosed in Japanese Kokoku 57-23693.

One attempt to develop an aqueous developable, flexible printing plate is illustrated in U. S. Patent No. 4,275,142, Photosensitive Compositions and Printing Plates Containing Same, Hosaka et al., June 23, 1981, which discloses random copolymers of various acrylates with conjugated dienes including isoprene and butadiene. The copolymers are prepared by mixing the respective monomers together in a solvent and heating. The copolymers are described as useful in photosensitive compositions for the preparation of water-developable printing plates. However, random copolymers of this type are not able to achieve the desired physical properties when made into flexo plates.

European Patent Application 0 298667 published January 11, 1989, Applicant, The Dow Chemical Co., inventors McGrath et al., discloses triblock polymers of the type ABA, where A can be a polymer segment of a $C_2$-$C_5$ alkyl methacrylate or methacrylic acid and B is a polymer segment of a conjugated diene. Typically A is t-butylmethacrylate and B is butadiene or isoprene. The polymers can be hydrolyzed and the hydrolysis product wholly or partly converted to the corresponding ionomer with a base, e.g., potassium hydroxide. The ABA triblock polymers are made by sequential polymerization with a difunctional initiator. First, the diene is polymerized to form a living polymer (B), which is then treated with the acrylate monomer (A) to form the ABA triblock polymer. Uses mentioned for the polymers include elastomers, adhesives, bases, gaskets, containers for liquids, and impact modifiers. There is no suggestion of use in photosensitive compositions, and no suggestion as to how the physical properties desired by the applicants can be obtained.

Accordingly, it is an object of the invention to prepare a photocurable composition which is suitable as an aqueous developable, photosensitive layer on a flexible photosensitive article such as a flexible printing plate.

It is an object of the invention to prepare a solid, photosensitive layer which is flexible, yet strong and durable.

It is also an object to prepare a solid photosensitive layer which, when cured in an imagewise pattern, results in a relief pattern layer which easily and clearly transfers ink in instances the layer is that of a flexible printing plate.

It further is an object of the invention to prepare a water-developable flexographic printing plate comprising:

I. A photosensitive composition comprising:
    (a)
        (i) ABA triblock polymer,
        (ii) hydrolyzed ABA triblock polymer,
        or
        (iii) ABA triblock polymer at least partially converted to ionomer;
    (b) A photosensitive unsaturated compound;
    (c) A photoinitiator; and
II. A support for the composition of I; wherein:
    A is an alkyl acrylate or methacrylate polymer, and
    B is a conjugated diene polymer, preferably isoprene or butadiene.

It is a further object of the invention to prepare a flexible printing plate with superior physical properties.

It is another object of the invention to provide a printing plate based on an ABA triblock polymer having a structure predesigned for printing plate use.

The ABA triblock polymer as above defined can be formulated to make a photosensitive flexographic printing plate; the hydrolyzed ABA polymer makes a better plate; and the ionomerized ABA makes a still better plate (all being similarly formulated).

The invention is directed to making flexographic relief printing plates (which in preferred embodiments are water-developable) using photosensitive formulations based on certain ABA triblock polymers. The method of making ABA triblock polymers is known, as well as techniques to make their hydrolytic and ionomer derivatives, as disclosed in European Patent Application 0298667 to the Dow Chemical Company, cited above and fully incorporated here. Additional details for their preparation are given below. It will be understood that the total ABA polymer is a mixture of ABA with minor amounts of side products such as AB, B and A. The latter have little or no effect on the use of ABA in printing plates.

## The ABA Triblock Polymers

With respect to the ABA formula, A can be (in addition to the t-butylmethacrylate of the examples), methyl methacrylate, ethyl methacrylate, n-butyl acrylate, and the like. B can be a conjugated diolefinic hydrocarbon, preferably butadiene, isoprene, and also chloroprene, dimethylbutadiene and the like.

A living diene polymer (B) is prepared by use of about 0.001 to 1.0 percent by weight of a difunctional reactive anionic polymerization initiator. Suitable initiators include the metal alkyl compounds, preferably the lithium alkyls, most preferably sec-butyl lithium. the polymerization may be conducted with or without solvent at temperatures from -60°C to 75°C.

Next, the living diene polymer is contacted with a hydrolyzable methacrylate ester monomer having 2 to 5 carbons in the ester group under anionic polymerization conditions to prepare a methacrylate polymer block. the reaction may be quenched by any suitable technique, typically by addition of a low molecular weight alcohol, such as methanol.

The polymer can then be partially or wholly hydrolyzed by heating in the presence of an acid. Suitable acids include the aromatic sulfonic acids, preferably toluene sulfonic acid.

Further, the acid group on the methacrylic acid containing blocks may be neutralized, or ionomerized by adding a suitable basic reagent, such as an alkaline metal hydroxide, preferably potassium hydroxide.

Increasing the amount of A in the hydrolyzed or ionomerized ABA copolymer gives increased amounts of carboxyl functionality, which further facilitates washing of the plate. However, we have found that B must always exceed A (weight-wise) to give elastomeric properties to the copolymer. An A/B weight ratio of about 1/2-5 is useful, and 1/3-4 is preferred. Higher weights of A risk loss of elastomeric properties in the plate. The copolymer would then tend to behave as a plastic. In this regard, note that the copolymer is a thermoplastic elastomer. The methacrylate end blocks are thermoplastic whereas the diene midblock is elastomeric. Thus, with more end blocks the copolymer tends to behave as a plastic rather than an elastomer. These copolymers thus possess both properties in one molecule. Also, at higher weight of A there is risk of an undesirable increased tendency to mixing of the two phases and decreased microphase separation. The methacrylate endblocks and the diene midblocks are thermodynamically incompatible. Thus the methacrylate end blocks unite or "agglomerate" to form submicroscopic domains or "microphases" leading to a two-phase system, i.e., a discrete methacrylate microphase in a continuous rubber phase. Each diene chain is chemically joined to the methacrylate end blocks, and the end blocks are immobilized in the domains. This provides physical cross-linking and hence excellent physical properties. However, if one excessively increases the size of the endblocks (i.e., beyond the limits herein described), one risks mixing the two phases with consequent loss of the excellent physical properties of the copolymer formulations of the invention.

Ionomerization of the hydrolyzed polymer can be in the range of none at all to 100%. We have found that 50-75% ionomerization gives excellent results in plate preparation, and this range is preferred.

## Formulations

For use in printing plates, the invention employs two types of formulations. One type is for solvent casting and uses a solvent. The other is for extrusion and is solvent-free. For solvent casting, the unmodified, hydrolyzed, or ionomerized triblock polymer is dissolved in a solvent together with a photosensitive unsaturated compound (typically an acrylate), and a photoinitiator. This solution can be solvent cast in the usual way to produce a photopolymer plate, which can then be imaged and developed in the usual way to produce solid printing plates. Development can be by water and/or organic solvent, as hereinafter described.

Thus, a formulation for solvent casting will include:

(1) Unmodified, hydrolyzed, or ionomerized ABA triblock polymer;

(2) A solvent, e.g., toluene/methanol mixture, chloroform, etc.

(3) A photosensitive unsaturated compound, as described below; and

(4) Photoinitiator, as described below.

## The Photosensitive Unsaturated Compound

This material is a reactive monomer, typically an acrylate. Useful acrylates include those of the formula:

$$(CH_2=C(R^4)C(:0)-0-)_n-R^5$$

where $R^4$ is H or methyl and $R^5$ is an organic moiety having a valence of n, and n is 1 or more.

Such reactive monomers include, but are not limited to, trimethylolpropane triacrylate, hexanediol diacrylate, 1,3-butylene glycol diacrylate, diethylene glycol diacrylate, 1,6-hexanediol diacrylate, neopentyl glycol diacrylate, polyethylene glycol-200 diacrylate, tetraethylene glycol diacrylate, triethylene glycol diacrylate, pentaerythritol tetraacrylate, tripropylene glycol diacrylate, ethoxylated bisphenol-A diacrylate, trimethylolpropane triacrylate, dimethylolpropane tetraacrylate, triacrylate of tris(hydroxyethyl) isocyanurate, dipentaerythritol hydroxypentaacrylate, pentaerythritol triacrylate, ethoxylated trimethylolpropane triacrylate, triethylene glycol dimethacrylate, ethylene glycol dimethacrylate, tetraethylene glycol dimethacrylate, polyethylene glycol-200 dimethacrylate, 1,6-hexanediol dimethacrylate, neopentyl glycol dimethacrylate, polyethylene glycol-600 dimethacrylate, 1,3-butylene glycol dimethacrylate, ethoxylated bisphenol-A dimethacrylate, trimethylolpropane trimethacrylate, diethylene glycol dimethacrylate, 1,4-butanediol diacrylate, diethylene glycol dimethacrylate, pentaerythritol tetramethacrylate, glycerine dimethacrylate, trimethylolpropane dimethacrylate, pentaerythritol trimethacrylate, pentaerythritol dimethacrylate, pentaerythritol diacrylate, urethanemethacrylate or acrylate oligomers and the like which can be added to the photopolymerizable composition to modify the cured product. Monoacrylates such as cyclohexyl acrylate, isobornyl acrylate, lauryl acrylate and tetrahydrofurfuryl acrylate and the corresponding methacrylates are also operable as reactive diluents.

## Photoinitiators

The formulations comprising the novel materials of this invention require a photoinitiator. A large number are available and useful.

Photoinitiators for the photocurable composition include the benzoin alkyl ethers, such as benzoin methyl ether, benzoin ethyl ether, benzoin isopropyl ether and benzoin isobutyl ether. Another class of photoinitiators are the dialkoxyacetophenones exemplified by 2,2-dimethoxy-2-phenylacetophenone, i.e., Irgacure® 651 (Ciba-Geigy); and 2,2-diethoxy-2-phenylacetophenone. Still another class of photoinitiators are the aldehyde and ketone carbonyl compounds having at least one aromatic nucleus attached directly to the carboxyl group. These photoinitiators include, but are not limited to, benzophenone, acetophenone, o-methoxybenzophenone, acenaphthenequinone, methyl ethyl ketone, valerophenone, hexanophenone, alpha-phenylbutyrophenone, p-morpholinopropiophenone, dibenzosuberone, 4-morpholinobenzophenone,4'-morpholinodeoxybenzoin, p-diacetylbenzene, 4-aminobenzophenone, 4'-methoxyacetophenone, benzaldehyde, alpha-tetralone, 9-acetylphenanthrene, 2-acetylphenanthrene, 10-thioxanthenone, 3-acetylphenanthrene, 3-acetylindone, 9-fluorenone, 1-indanone, 1,3,5-triacetylbenzene, thioxanthen-9-one, xanthene-9-one, 7-H-benz[de]-anthracene-7-one, 1-naphthaldehyde, 4,4'-bis(dimethylamino)-benzophenone, fluorene-9-one, 1'-acetonaphthone, 2'-acetonaphthone, 2,3-butanedione, acetonaphthene, benz[a]anthracene 7.12 dione, etc. Phosphines such as triphenylphosphine and tri-o-tolylphosphine are also operable herein as photoinitiators.

## Other Additives

Other additives to the photocurable composition can be included. To inhibit premature crosslinking during storage of the prepolymer containing compositions of this invention, thermal polymerization inhibitors and stabilizers are added. Such stabilizers are well known in the art, and include, but are not limited to, hydroquinone monobenzyl ether, methyl hydroquinone, amyl quinone, amyloxyhydroquinone, n-butylphenol, phenol, hydroquinone monopropyl ether, phenothiazine and nitrobenzene, and mixtures thereof. Such additives are used in an amount within the range of from about 0.01 to about 2% by weight of the prepolymer. These stabilizers are effective in preventing crosslinking of the prepolymer composition during preparation, processing and storage.

The compositions also may contain up to about 50% by weight of an inert particulate filler which is essentially transparent to actinic light. Such fillers include the organophilic silicas, bentonites, silica and powdered glass. Such fillers can impart desirable properties to the photocurable compositions and reliefs on printing plates containing those compositions. It is often desirable to add an antioxidant. Typically, 2,6-ditertiary-butyl-4-methylphenol ("BHT") is useful.

Summarizing, formulations using the herein described polymers suitably include the following (in parts by weight):

(1) Triblock polymer, unmodified, hydrolyzed, or ionomerized, about 50-99, preferably about 75-95;
(2) Photosensitive unsaturated compound, about 0.1-50, preferably about 0.1-20;
(3) Photoinitiator, about 0.01-5.0, preferably about 0.1-3.0.

Additionally, in a formulation for solvent casting, the formulation contains enough solvent to dissolve the above materials. For extrusion, the solvent in omitted.

## Preparation of Plate

The photocurable compositions comprising the above-described unmodified, hydrolyzed, or ionomerized ABA triblock polymers can be shaped and formed as a solid layer of suitable thickness according to conventional solvent casting, i.e., dissolving the composition in a solvent, shaping the solution into a film or plate, and removing the solvent, e.g., by oven-drying. Alternately, conventional extrusion calendaring or hot press techniques can be used. Solid layers of the photosensitive composition in the form of a film can be adhered to supports such as those comprising polyester, nylon, or polycarbonate. Other suitable supports include woven fabrics and mats, e.g., glass fiber fabrics or laminated materials made of, for example, glass fibers and plastics; and steel or aluminum coated plates. It is preferred that the supports be dimensionally stable and resistant to the washout solutions.

It may be desirable to protect the photosensitive surfaces from contamination by dirt and dust during storage before being exposed and washed. Such protection may be accomplished by application of a flexible protective cover sheet to the side of the photocurable composition opposite that of the support. In addition, the photocurable compositions can sometimes be tacky, and in such case it may be desirable to apply a release film to the surface of the photosensitive layer before application of the coversheet. The release film may consist of a thin, flexible, water-dispersible polymeric film placed in intimate contact on the surface of the photocurable composition. Such release films are well known in the art.

## Exposure and Development

Photosensitive articles comprising a support having a solid layer or surface comprising the invention photocurable compositions, e.g., solid flexographic printing plates, can be processed by well known techniques for imagewise exposure to actinic light. Preferably, the light should have a wavelength of about 230-450 mn. Exposure is through a negative placed between the light source and the photosensitive surface. Suitable sources of light include Type RS sunlamps, carbon arc lamps, xenon arc lamps, mercury vapor lamps, tungsten halide lamps, and the like. Ultraviolet light (UV) in general is useful.

Exposure periods depend upon the intensity of the actinic light, thickness of the plate, and the depth of the relief desired on the printing plate. Exposure periods of from 2 to 20 minutes are generally suitable.

After exposure and removal of the negative, the unexposed areas of the photosensitive surface can be developed in washout solutions as herein described. Imaged plates made with unmodified ABA triblock polymers (i.e., neither hydrolyzed or ionomerized) may be washed with organic solvents, e.g., toluene/methanol mixture, 95:5 by volume, chloroform, tetrahydrofuran and the like. As noted, a preferred washout solution for plates using the hydrolyzed or ionomerized formulations of this invention is a dilute aqueous surfactant solution. Plain water (preferably warm) is also useful (preferably with brushing). This feature is particularly advantageous in that it avoids problems of disposing of washout solutions containing organic solvents.

The following Examples illustrate without limiting the invention.

### Example 1

### Synthesis of t-Butylmethacrylate-Isoprene-t-Butylmethacrylate Block Copolymer

As noted above, materials and methods for the preparation of the polymers used in this invention are known. However, to facilitate an understanding of our techniques, we offer below the methods that we used to prepare the starting ABA triblock copolymers.

0.19g of bis[4-(1-phenylvinyl)phenyl]ether was weighed into a 1 L 3-neck round-bottom glass equipped with a magnetic stir-bar. 528g of benzene was distilled in and flushed with dry argon. 1.35 ml of 1.3 M sec-butyllithium in cyclohexane was charged to the above solution and stirred at 65°C for 2 hours and cooled to room temperature in 1 hour. 30.65g of doubly-distilled isoprene was syringed in at 25°C. The solution was stirred at 50°C for 2 hours. An aliquot (about 0.2g) of the above solution was syringed out and quenched in excess of methanol for GPC analysis.

The above solution was cooled to 5°C and 8.14g of t-butylmethacrylate monomer was added at 5°C and stirred for 30 minutes and quenched with methanol (0.787g). The polymer was collected and dried at room temperature under vacuum for 24 hours. The polymer was characterized by IR, NMR, and GPC.

## TABLE 1

### Synthesis of ABA Triblock Polymer

|  | Example 1 | Example 2 |
|---|---|---|
| Initiator, mols/liter | $8.9 \times 10^{-4}$ | $1.15 \times 10^{-3}$ |
| Isoprene, mols/liter used | 0.89 | 0.80 |
| TBMA[1], mols/liter used | 0.10 | 0.17 |
| Weight % TBMA observed in ABA polymer | 23.41 | 32.4 |
| $M_n$ of ABA polymer observed[2] | 270,000 | 261,000 |
| Microstructure of polyisoprene in ABA polymer, weight %[3] |  |  |
| 1,4 | 93.3 | 92.6 |
| 3,4 | 6.7 | 7.4 |

(1) t-butylmethacrylate.
(2) number average from GPC (polyisoprene standards).
(3) from $^1$H NMR.

Note:   Analytic data are for the ABA polymer as recovered and prior to hydrolysis.  Hydrolysis (if any) converts the acrylate ester to methacrylic acid with corresponding weight loss in the acrylate component of ABA (about 1/3 in the case of TMBA) but does not affect polyisoprene microstructure.

Properties are given in Table 1.

## Example 2

This Example was carried out in substantially the same manner as Example 1 except that the difunctional initiator was 0.102g m-diisopropenylbenzene with the sec-butyllithium. Polymer properties are given in Table 1.

## Example 3

### Hydrolysis of Triblock Polymer and Formulation

50g of the t-butylmethacrylate-isoprene-t-butylmethacrylate block copolymer prepared by the procedure of Example 2 was charged with 425g toluene and 25g methanol to a 1 L resin kettle equipped with a condenser and an overhead stirrer. 1.118g of p-toluenesulfonic acid monohydrate was added to the above solution. Hydrolysis was carried out at 85° for 9 hours under a constant slow flow of argon. Hydrolysis converted the t-butylmethacrylate units to methacrylic acid.

216g of the above solution containing 10% solids was formulated with 1.31g hexanediol diacrylate, 1.31g hexane diol dimethacrylate, 0.26g Irgacure-651® (photoinitiator) and 0.05g BHT (from Aldrich Chemical Co., Milwaukee, Wis.). A 60-mil thick plate was cast. The plate was found to be slightly tacky and hazy. The imagewise exposed plate was washable in 1% $Na_2CO_3$ solution, though not as easily as plates formulated with ionomerized products. The developed plate had good printing qualities.

## Example 4

### Ionomerization of Hydrolyzed ABA Triblock Polymers

To 184g of the solution prepared in Example 3 was added 1.67g potassium hydroxide in 10g methanol to form the 75% ionomer of the hydrolysis product. In this reaction 75% of the methacrylic acid units were neutralized. The 75% ionomer was then formulated with 1.21g hexanediol diacrylate, 1.21g hexane diol dimethacrylate, 0.24g Irgacure-651®, and 0.05g BHT. A 60-mil thick plate was cast, imagewise exposed, and developed by washing in an aqueous surfactant solution (4.5% Triton RW-150™). The plate was clear and had excellent printing qualities. Properties are given in Table 2.

### Physical Properties

The compositions and printing plates of the instant invention are characterized by certain highly desirable physical properties, as more fully described below.

The properties discussed below apply to plates of the invention, i.e., formulated with acrylates and photoinitiators, e.g. as described in Examples 3 and 4.

**Tensile Strength and Elongation.** Tensile strength and elongation are related to the amount of energy that can be stored in the polymer prior to breaking or rupture and can be correlated to the ability of the plate to withstand chipping or fracture on press. High values of both properties are desired, e.g., about 300 - 1000 psi for tensile strength, and about 200 - 800% for elongation.

**Modulus** is related to the stiffness of the polymer and is a measure of the ability of the plate to conform to the ink analox roll or substrate during impression on press. Polymers with high modulus values will be very stiff and rigid and will not pick up or transfer ink well. Modulus values in the range of about 300 - 800 psi are preferred.

**Resilience** is a measure of the resistance the polymer has towards deformation. A high resilience is desired to prevent areas of the plate from being compressed and not printing. Resilience values in the range of about 30 - 60% are generally desired.

**Shore A Hardness** Shore A hardness is similar to modulus in that a polymer with a high hardness value will not conform easily to the analox roll or substrate, and ink transfer will be poor. Values in the range of about 35 - 70° are deemed desirable for flexographic printing application.

Herein, tensile strength, elongation, and modulus were determined by ASTM D 412; resilience by ASTM D 2632-79; and Shore A hardness by ASTM D 2240. All test plates were formulated with 5% hexane diol diacrylate, 5% hexane diol dimethacrylate, 1% Irgacure-651®, 2% BHT and balance ABA triblock polymer, optionally hydrolyzed or ionomerized, as the case may be. In actual use the plates would be about 67 - 250 mils thick.

Properties of plates made by the procedure of Example 4 are given in Table 2.

## Table 2

### Properties of Flexographic Plates Made with Formulated ABA Triblock Ionomers[1]

| Property of Ionomer | 75% K Ionomer (Example 4) | 50% K Ionomer[2] |
|---|---|---|
| Wt % methacrylic acid in ionomer | 15.8 | 15.6 |
| Tensile, psi | 814 | 594 |
| Elongation, % | 339 | 443 |
| Modulus, psi | 357 | 628 |
| Shore A, ° | 55 | 57 |
| Resilience, % | 52 | 57 |

(1) Formulations comprised 4% hexane diol diacrylate, 5% hexane diol dimethacrylate, 1% Irgacure-651, 2% BHT, and balance the partially ionomerized ABA polymer. Tests were made on 20 mil thick plates.

(2) Prepared by same procedure of Example 4, except 50% ionomerized.

## Claims

1. A photosensitive composition comprising:

    (a)
        (i) an ABA triblock polymer,
        (ii) a hydrolysed ABA triblock polymer,
        or
        (iii) an ABA triblock polymer at least partially converted to ionomer;
        wherein A is an alkyl acrylate or methacrylate polymer, and
        B is a conjugated diene polymer;
    (b) a photosensitive unsaturated compound; and
    (c) a photoinitiator.

2. A composition according to claim 1 wherein the ABA triblock polymer is hydrolysed.

3. A composition according to claim 1 or 2 wherein the ABA triblock polymer is at least partially converted to ionomer.

4. A composition according to claim 3 wherein the extent of ionomerisation is from 50 to 75%.

5. A composition according to any one of the preceding claims wherein in (a), A is t-butylmethacrylate and B is isoprene.

6. A composition according to any one of the preceding claims wherein in (a) A/B weight ratio is from 1:2 to 1:5.

7. A composition according to claim 6 wherein the A/B weight ratio is from 1:3 to 1:4.

8. A composition according to any one of the preceding claims, which comprises as photosensitive saturated compound, a mixture of hexanediol dimethacrylate and hexanediol diacrylate.

9. A composition according to claim 8, which comprises equal parts of hexanediol dimethacrylate and hexanediol diacrylate.

10. A composition according to any one of the preceding claims which comprises by weight, from 50 to 99 parts of the polymer (a); from 001 to 50 parts of the photosensitive unsaturated compound (b); and from 0.01 to 5.0 parts of the photoinitiator (c).

11. A composition according to claim 10, which comprises from 75-95 parts of the polymer (a); from 0.1 to 20 parts of the photosensitive unsaturated compound (b); and from 0.01 to 3.0 parts of the photoinitiator (c).

12. A method of preparing a photosensitive composition as claimed in any one of claims 1 to 11 comprising mixing together in a solvent:
    (a)
        (i) an ABA triblock polymer,
        (ii) a hydrolysed ABA triblock polymer, or
        (iii) an ABA triblock polymer at least partially converted to ionomer;
    (b) a photosensitive unsaturated compound; and
    (c) a photoinitiator.

13. A photosensitive flexographic relief printing plate comprising a support, and thereon a layer of a photosensitive composition as claimed in any of claims 1 to 11.

14. Plate according to claim 13 wherein the photosensitive layer of the plate has a tensile strength from 2,060 to 4,140 kPa (300 to 600 psi), an elongation of from 200 to 600%, a modulus from 2,060 to 4,480 kPa (300 to 650 psi), a resilience of from 30 to 60%, and a Shore A hardness from 40 to 65°C.

15. Method of preparing a photosensitive flexographic printing plate comprising applying to a support a layer of a photosensitive composition as claimed in any one of claims 1 to 11.

16. Method of exposing and developing a flexographic printing plate which method comprises exposing a plate comprising a layer of a photosensitive composition as claimed in any one of claims 1 to 11, to UV radiation through a negative, thereby providing exposed and non-exposed areas of composition on the plate, and developing the plate by removing the non-exposed areas by washing the plate with an aqueous solution.

17. Apparatus comprising an exposed flexographic printing plate obtainable by the method of claim 16.

**European Patent Office**

## EUROPEAN SEARCH REPORT

Application Number

EP  92 31 0510

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | EP-A-0 480 335 (HOECHST AKTIENGESELLSCHAFT)<br>* page 2, line 1 - line 2 *<br>* page 3, line 27 *<br>* page 3, line 33 - line 34 *<br>* page 4, line 7 *<br>* page 4, line 35 - line 39 *<br>* page 9, line 16 *<br>--- | 1-17 | G03F7/033 |
| X | DE-U-9 016 663 (HOECHST AKTIENGESELLSCHAFT)<br>* page 1, line 4 - line 8 *<br>* page 2, line 25 - line 27 *<br>* page 4, line 10 - line 15 *<br>* page 9, line 7 - line 13 *<br>--- | 1-17 | |
| X | EP-A-0 333 169 (CANON KABUSHIKI KAISHA)<br>* page 5, line 6 - line 16 *<br>* page 5, line 47 - line 52 *<br>* page 11, line 40 - line 49; claim 2 *<br>--- | 1 | |
| A | US-A-4 369 246 (G.Y.Y.T. CHEN ET AL.)<br>* column 4, line 9 - line 62 *<br>----- | 1-17 | **TECHNICAL FIELDS SEARCHED (Int. Cl.5)**<br><br>G03F |

The present search report has been drawn up for all claims

| Place of search | Date of completion of the search | Examiner |
|---|---|---|
| THE HAGUE | 03 MARCH 1993 | DUPART J-M.B. |